# EUROPÄISCHE PATENTANMELDUNG

(11) **EP 4 407 841 A1**
(43) Veröffentlichungstag der Anmeldung: **31.07.2024**
(21) Anmeldenummer: 23153972.7
(22) Anmeldetag: 30.01.2023
(51) Int. Cl.: H02K 3/04, H02K 11/33, H02K 3/12, H02K 3/50, H02K 9/22

(54) **ELEKTROMOTOR**

(71) Anmelder: Siemens Aktiengesellschaft, 80333 München (DE)
(72) Erfinder: Brütting, Frank, 91054 Erlangen (DE)
(74) Vertreter: Siemens Patent Attorneys

(57) **Zusammenfassung**

Die Erfindung betrifft einen Elektromotor (10) mit:
- einem Stator (11) mit einer Mehrzahl von als Stäbe ausgestalteten Feldleitern (12),
- einer Mehrzahl von Leistungselektronikbauteilen zur Ansteuerung der Feldleiter (12),
wobei
- die Leistungselektronikbauteile auf einer oder mehreren Leiterplatten (15) angeordnet sind,
- wenigstens eine Leiterplatte (15) auf wenigstens einer Kühlplatte (16) angeordnet ist,
- die Kühlplatte (16) so angeordnet ist, dass die Feldleiter (12) mit den Feldleitern (12) elektrisch verbundenen Stromleitern (18) mit der Kühlplatte (16) in mechanischer Wirkverbindung stehen,
dadurch gekennzeichnet,
- die Kühlplatte (16), in mindestens zwei Teilsegmente (16-1), (16-2) segmentiert ist, die elektrisch voneinander isoliert sind,
- wobei eine Trennungsfläche (20) zwischen den Teilsegmente (16-1), (16-2) weniger als 20% einer Kühlfläche (22) beträgt und
- die Leiterplatten (15) zur Stromversorgung mit den Teilsegmenten (16-1), (16-2) der Kühlplatte (16) elektrisch kontaktiert sind.

## Beschreibung

Die Erfindung betrifft einen Elektromotor mit einer ständerseitigen Stabwicklung.

Elektromotoren können ständerseitig eine Stabwicklung aufweisen. Dabei weist der Ständer (Stator) eine Reihe von Stäben anstelle von gewickelten Drahtleitern als Feldleiter auf. Die Stäbe weisen im Vergleich zu herkömmlichen Wicklungen eine geringe Induktivität auf. Daher ist für die Erzeugung eines vorgegebenen Magnetfelds ein vergleichsweise hoher Stromfluss erforderlich. Ein Motor dieser Bauart ist in der EP19167289 A1 beschrieben.

Dieser hohe Stromfluss erfordert aber durch den geringen Widerstand der Stäbe nur eine vergleichsweise geringe Spannung von beispielsweise 12 V. Die geringe Spannung ermöglicht es, die Komponenten der Wechselrichter, mit denen die Stäbe angesteuert werden, in geringen Abständen zueinander anzuordnen. So können die Komponenten der Leistungselektronik beispielsweise auf einer oder mehreren Platinen (Leiterplatten) angeordnet werden, die nahe am (bevorzugt im Gehäuse des) Elektromotor angeordnet werden. Die Stäbe können dabei direkt oder über elektrisch leitende stabartige Verbindungselemente als mechanischer Träger der Platinen verwendet werden.

Die Leiterplatten sind dabei auf Kühlplatten montiert und über elektrische Stromschienen einzelnen kontaktiert. Dabei liegen die Stromschienen auf den Leiterplatten und sind mit diesen über Schraubenverbindungen kontaktiert. Die Schraubenverbindungen sind allerdings auch in den Kühlplatten (von dieser mechanisch entkoppelt) befestigt, um eine sichere Kontaktierung herzustellen. Hieraus stellt sich jeweils das Problem der Isolierung zwischen der Schraubverbindung und der Kühlplatte, was für jede einzelne Schraubenverbindung durch eine entsprechende Hülse gelöst werden muss. Insbesondere wenn eine Leiterplatte aufgrund defekter Einzelbauteile gewechselt werden muss, müssen die -in der Regel zwei- Stromschienen die bis zu 150 Leiterplatten einspannen und mit Strom versorgen, abgeschraubt werden und anschließend wieder vollständig isoliert und aufgeschraubt werden.

Der Erfindung liegt die Aufgabe zugrunde, einen Elektromotor mit einer ständerseitigen Stabwicklung sowie einer integrierten Leistungselektronik bereitzustellen, der gegenüber dem Stand der Technik einen niedrigeren Reparaturaufwand beim Austausch von Leiterplatten der Leistungselektronik erfordert.

Die Lösung der Aufgabe besteht in einem Elektromotor mit den Merkmalen des Patentanspruchs 1.

Dieser Elektromotor umfasst
- einen Stator mit einer Mehrzahl von als Stäbe ausgestalteten Feldleitern,
- eine Mehrzahl von Leistungselektronikbauteilen zur Ansteuerung der Feldleiter wobei
- die Leistungselektronikbauteile auf einer oder mehreren Leiterplatten angeordnet sind, und
- wenigstens eine Leiterplatte, die auf wenigstens einer Kühlplatte angeordnet ist,
- wobei die Kühlplatte so angeordnet ist, dass die Feldleiter mit Stromleitern, die mit den Feldleitern elektrisch verbunden sind, mit der Kühlplatte in mechanischer Wirkverbindung stehen. (Das kann mittels Durchgangsbohrungen durch die Kühlplatte erfolgen. Die mechanische Wirkverbindung kann aber auch indirekt zur Kühlplatte, beispielsweise über Bohrungen in den Leiterplatten erfolgen, wobei die Leiterplatten an diesen Bohrungen teilweise über den Rand der Kühlplatte überstehen). Die Stromleiter bilden demnach stromleitende Verbindungselemente zwischen den Feldleitern und den Leiterplatten und schlussendlich zu den Leistungselektronikbauteilen (auch Halbleiterschalter). Diese haben aufgrund der mechanischen Wirkverbindung auch eine tragende Eigenschaft für die Kühlplatte, wobei sie gegenüber dieser elektrisch isoliert sind.
- Die Erfindung zeichnet sich dadurch aus, dass
- die Kühlplatte, in mindestens zwei Teilsegmente 16-1, 16-2 segmentiert ist, die elektrisch voneinander isoliert sind,
- wobei eine Trennungsfläche 20 zwischen den Teilsegmenten 16-1, 16-2 weniger als 20% einer Kühlfläche 22 beträgt und
- die Leiterplatten 15 zur Stromversorgung mit den Teilsegmenten 16-1, 16-2 der Kühlplatte 16 elektrisch kontaktiert sind.

Die Stromversorgung des Elektromotors erfolgt demnach zunächst über die Teilsegmente der Kühlplatte(n) zu den Leiterplatten und den darauf angeordneten Leistungselektronikbauteilen und hiervon weiter über die Stromleiter zu den Feldleitern des Stators.

Der beschriebene Elektromotor unterscheidet sich dabei von herkömmlichen Elektromotoren darin, dass der Ständer (Stator) eine Reihe von Stäben anstelle von gewickelten Drahtleitern als Feldleiter aufweist. Die Stäbe weisen im Vergleich zu herkömmlichen Wicklungen eine geringe Induktivität auf. Daher ist für die Erzeugung eines vorgegebenen Magnetfelds ein vergleichsweise hoher Stromfluss erforderlich.

Aus dem Aufbau der Stabwicklung ergeben sich grundlegende Vorteile im Betrieb der Maschine: Durch die segmentweise Steuerbarkeit des magnetischen Flusses zwischen je zwei Feldleitern können weit flexiblere Formen an Magnetfeldern in die Maschine eingeprägt werden, als es mit einer verteilten Wicklung und deren inhärenten Überlagerungseffekten möglich wäre. Hierdurch ergeben sich viele (regelungstechnische) Vorteile im Hinblick auf die Laufeigenschaften der Maschine. Weiterhin zieht der Ausfall einer Phase ((der Ansteuerung) eines Feldleiters) weitaus geringere Folgen nach sich, als es z.B. bei einer doppel-dreiphasigen oder gar normalen dreiphasigen Maschine der Fall wäre. Da diese Effekte zudem von den benachbarten Phasen sehr gut kompensiert werden können, sinkt mit jedem Phasenausfall bei entsprechender Ausregelung fast ausschließlich die Antriebsleistung um nur einen kleinen Bruchteil, ohne die restlichen Eigenschaften nennenswert zu beeinflussen.

Der Vorteil gegenüber dem Stand der Technik von Motoren dieser Bauart besteht bei dem beschriebenen Elektromotor darin, dass die Stromschienen nicht auf den Leiterplatten angeordnet sind, sondern die Kühlplatte selbst die Stromversorgung der Leiterplatten gewährleisten. Auf diese Weise kann jede Leiterplatte einzelnen durch Lösen der Verschraubung, die in der Regel auch die Kontaktierung mit den Stromschienen darstellt, ohne großen Aufwand entfernt und ausgetauscht werden. Somit muss also für eine Reparatur nicht große Teile oder sogar der gesamte Aufbau von allen Leiterplatten zerlegt werden, was bei Reparaturarbeiten an der Leistungselektronik eine erhebliche Einsparung des Arbeitsaufwandes bedeutet und somit einen Kostenvorteil darstellt. Die Reparaturkosten werden deutlich reduziert.

Ferner wird durch diese konstruktive Ausgestaltung, die darin besteht, die Kühlplatte in mindestens zwei segmentierte Abschnitte aufzuteilen und zur Kontaktierung und somit zur Stromzufuhr zu verwenden, bewirkt, dass zum einen die Montage der Leiterplatten nicht behindert wird, aber auch gleichzeitig die gesamte Auflagefläche der Leiterplatten auf der Kühlplatte, als Kühlfläche genutzt werden kann. Eine größere elektrische Kontaktfläche zur DC-Versorgung (statt einer kleineren Kontaktfläche zu entsprechenden DC-Verschienungen) ist ebenfalls von Vorteil. Zwar wäre eine metallische Stromschiene, die in einer Kühlplatte versenkt ist, grundsätzlich auch wärmeleitend, sie entfaltet aber keine kühlende Wirkung, da sie gegenüber der Kühlplatte elektrisch und damit auch weitgehend thermisch isoliert ist (diese Isolierung entfällt in vorteilhafter Weise in der Regel ebenfalls). Es erfolgt also nach Aufheizung der Stromschiene von dieser keine nennenswerte Wärmeabfuhr und somit wirkt sie nicht als Kühlplatte.

Dabei sei der Begriff Kühlfläche als die Fläche definiert, auf der die Leiterplatte zumindest indirekt flächig aufliegt. Gegebenenfalls kann es zweckmäßig sein aus technischen Gründen, z. B. zur zusätzlichen elektrischen Isolierung oder zur mechanischen Dämpfung, zwischen Leiterplatte und Kühlplatte eine Zwischenschicht oder Folie anzuordnen. Dies wird in diesem Zusammenhang auch als flächiges Aufliegen der Leiterplatte auf der Kühlfläche angesehen, da die Kühlfläche für die Aufnahme von Wärme aus der Leiterplatte bereitsteht. Die Trennfläche ist die Fläche, die bei einer senkrechten Betrachtung auf die Kühlplatte zwischen den Teilsegmenten der Kühlplatte angeordnet ist und die zur elektrischen Isolierung zwischen den Teilsegmenten der Kühlplatte dienen.

Hierbei ist zu berücksichtigen, dass man allgemein für den beschriebenen Motor nicht zwingend genau zwei stromzuführende Potentiale verwendet. Vorteilhaft ist es auch, duplizierte Potentiale oder z.B. drei Potentiale mit Zwischenkreis-Mittelpunkt oder doppelte (redundante) Zwischenkreise zu verwenden, wobei mehr als zwei Stromleiter benötigt werden.

In einer Ausgestaltungsform der Erfindung erfolgt die Kontaktierung der Leiterplatte an Kontaktstellen mittels eines Befestigungsmittels an der Kühlplatte. Das Befestigungsmittel kann bevorzugt eine Verschraubung sein. Durch die Kontaktierung mittels eines Befestigungsmittels können zwei notwendige Anforderungen nämlich die Kontaktierung und die Befestigung zwischen Kühlplatte und Leiterplatte mit einer Vorrichtung erfolgen, was zusätzlichen technischen Aufwand erspart. Neben einer Verschraubung für die Kontaktierung wären auch Klick-Verschlüsse oder Spannverbindungen zweckmäßig.

Ferner ist es vorteilhaft, wenn die Kühlplatte 16 mit einer Wärmesenke 38 in thermische Verbindung stehen. Somit kann die Wärme, die von den Bauteilen über die Leiterplatten in die Kühlplatte geleitet wird, gut wieder abgeleitet werden. Besonders bevorzugt ist die Wärmesenke in Form einer Kühlleitung ausgestaltet, die wiederum bevorzugt in einer horizontalen Ebene bezogen auf die Kühlfläche die Kühlplatte durchläuft.

Die Teilsegmente der Kühlplatte sind ferner bevorzugt ringförmig oder ringsektorförmig ausgestaltet. Auf diese Weise lässt sich eine gute Kombination aus guter Kontakttierbarkeit der Leiterplatten und guter Wärmeabfuhr erzielen. Dabei ist es zudem vorteilhaft, wenn die Kühlplatte aus Aluminium oder Kupfer oder aus einer Legierung dieser Metalle gebildet ist.

Die Leiterplatten können kreis- oder ringsektorförmig ausgestaltet sein. Leiterplatten mit dieser Form lassen sich zu einem Kreis oder Ring zusammensetzen und somit optimal an die Form der elektrischen Maschine angepasst an einem axialen Ende der Maschine anordnen, wobei gleichzeitig eine hohe Modularität erreicht wird.

Die Begriffe "axial", "radial" und "tangential" beziehen sich dabei auf die Achse des Rotors und damit auf die entsprechende Symmetrieachse des Stators. Dabei beschreibt "axial" eine Richtung parallel zu dieser Achse, "radial" beschreibt eine Richtung orthogonal zur Achse, auf diese zu oder auch von ihr weg, und "tangential" ist eine Richtung, die in konstantem radialem Abstand zur Achse und bei konstanter Axialposition kreisförmig um die Achse herum gerichtet ist. Der Ausdruck "in Umfangsrichtung" ist mit "tangential" gleichzusetzen.

Werden die Begriffe "axial", "radial" und "tangential" in Bezug auf eine Fläche verwendet, bspw. eine Querschnittsfläche, beschreiben die Begriffe die Orientierung des Normalenvektors der Fläche, d.h. desjenigen Vektors, der senkrecht auf der betroffenen Fläche steht.

Weitere Ausgestaltungsformen der Erfindung und weitere Merkmale werden anhand der folgenden Figuren näher erläutert. Dabei handelt es sich um rein schematische Ausgestaltungsformen, die keine Einschränkung des Schutzbereichs darstellen.

Dabei zeigen:
- Figur 1: einen Elektromotor mit Kühlplatten zur Entwärmung von Leiterplatten in Seitenansicht,
- Figur 2: den Elektromotor in Frontansicht,
- Figur 3: eine vergrößerte Darstellung der Figur 1 im Ausschnitt der Kühlplatten in Seitenansicht mit Stromschienen nach dem Stand der Technik,
- Figur 4: der gleiche Ausschnitt wie in Figur 3 mit modifizierter Anordnung der Stromzuführung,
- Figur 5: einen dreidimensionalen Querschnitt und Ausschnitt aus einer Kühlplatte mit angedeuteter Leiterplatte,
- Figur 6,: eine Draufsicht auf eine Kühlplatte mit angedeuteter Leiterplatte,
- Figur 7,: einen Querschnitt durch eine Kühlplatte durch eine Verschraubung,
- Figur 8: einen Querschnitt durch eine Kühlplatte, mit oberflächigen Kühlleitungen,
- Figur 9: einen Querschnitt durch eine Kühlplatte mit zentral angeordneten Kühlleitungen und
- Figur 10: eine dreidimensionale Darstellung einer Kühlplatte mit ringsegmentförmig ausgestalteten Teilsegmenten.

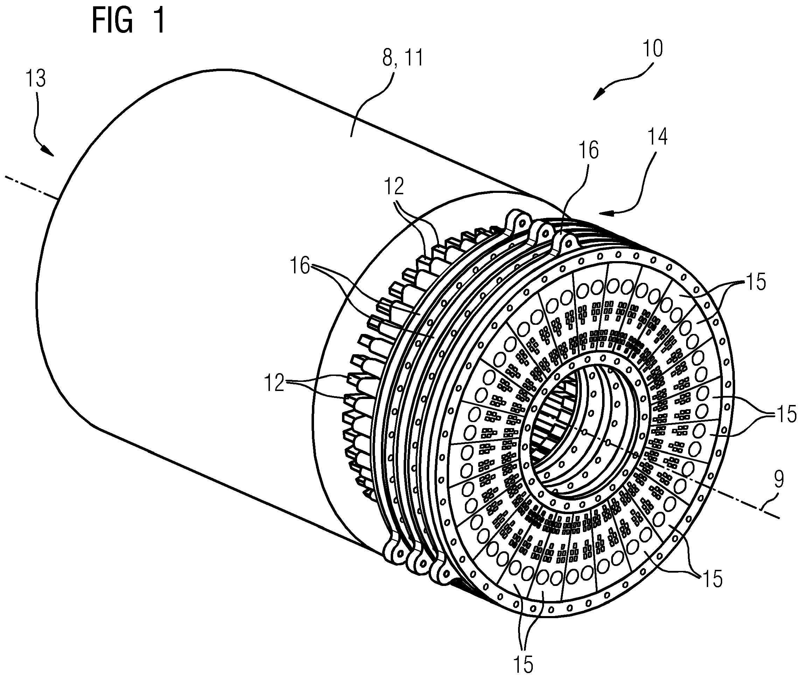

Figur 1 stellt eine isometrische Ansicht eines Elektromotors 10 dar, der ein Ausführungsbeispiel für die Erfindung ist. Der Elektromotor 10 umfasst einen Stator 11 und einen im Wesentlichen im Stator 11 angeordneten Rotor, der in Figur 1 nicht sichtbar ist. Der Rotor ist drehfest mit einer Welle verbunden, die ebenfalls in Figur 1 nicht dargestellt ist. Durch elektromagnetische Wechselwirkung des Rotors mit einem bestromten Stator 11 wird der Rotor um eine Achse 9 in Drehung versetzt. Der Rotor ist dabei vom Stator 11 durch einen Luftspalt getrennt.

In anderen Ausführungsformen kann es sich bei dem Elektromotor 10 auch um einen Außenläufermotor oder Glockenankermotor handeln.

Der Stator 11 umfasst als Feldleiter eine Mehrzahl von starren und geraden Leiterstäben 12. Diese Leiterstäbe 12 sind auf der in Figur 1 abgewandten Stirnseite 13 über einen Kurzschlussring miteinander verbunden. Auf der Rückseite 14 des Elektromotors 10 werden die Leiterstäbe 12 durch jeweils zugehörige Wechselrichtermodule einzeln gespeist. Da es sich bedingt durch die Leiterstäbe 12 um einen bei niedrigen Spannungen betriebenen Elektromotor 10 handelt, können die Wechselrichtermodule zusammen mit anderen Komponenten der Elektronik (Gleichspannungswandler, Gleichrichter) verhältnismäßig eng zusammen auf Leiterplatten 15 angeordnet sein. Die Leiterplatten 15 sind dabei in diesem Beispiel ringsektorförmig und viele einzelne Platinen 15 bilden zusammen eine ringförmige Platinenstruktur aus. Die starr ausgebildeten Leiterstäbe können dabei aus einem metallischen Stab, beispielsweise einem Kupferstab oder durch einen festen Multifilamentleiter ausgebildet sein.

Während in den Beispielen davon ausgegangen wird, dass die Leiterplatten (Platinen) 15 Wechselrichtermodule tragen, ist es auch möglich, dass ein Teil der Leiterplatten 15 Gleichrichter und DC/DC-Wandler tragen.

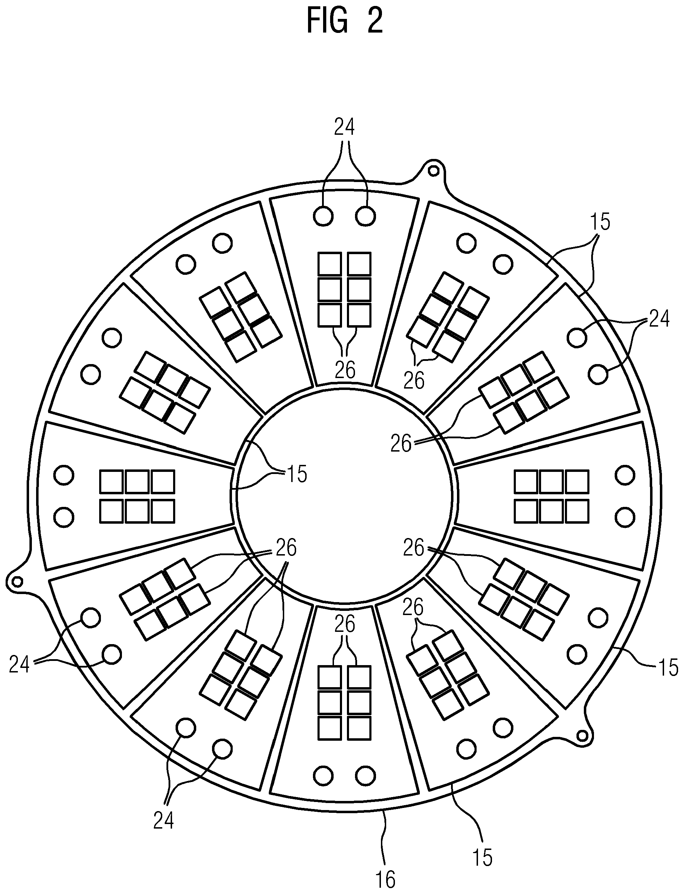

Figur 2 zeigt eine Aufsicht auf eine solche Platinenstruktur. Die Anzahl der in Figur 2 dargestellten Leiterplatten 15 ist dabei für eine bessere Übersichtlichkeit gegenüber dar Darstellung in Figur 1 verringert und stark vereinfacht dargestellt. Die konkrete Anzahl an solchen Leiterplatten 15 hängt von der konkreten Ausgestaltung des Elektromotors 10 ab, insbesondere der Anzahl der Leiterstäbe 12. Jede der Leiterplatten 15 umfasst mehrere Leistungselektronikbauteile, insbesondere Halbleiterschalter 26.

Weiterhin kann ein Teil der Leiterplatten 15 oder alle Leiterplatten 15 in den Figuren nicht dargestellte Treiberschaltungen und andere elektronische Komponenten wie Kondensatoren umfassen. Die Halbleiterschalter 26 sind Leistungshalbleiter wie beispielsweise IGBTs, MOSFETs oder JFETs und können abhängig von der Verschaltung zusätzlich nicht gezeigte Dioden umfassen. Die Halbleiterschalter 26 sind beispielsweise als Halbbrücken verschaltet. Ein nicht gezeigter Kondensator kann beispielsweise einen Zwischenkreiskondensator der Halbbrücken darstellen. Die Halbleiterschalter 26 einer Leiterplatte 15 können dabei einer einzelnen Phase zugeordnet sein oder aber mehreren Phasen.

Da bei dem Elektromotor 10 gegenüber herkömmlichen Motoren mit Wicklungen verhältnismäßig hohe Ströme in den Leiterstäben nötig sind, sind bevorzugt mehrere Wechselrichter zu deren Bestromung parallelgeschaltet. Dies kann beispielsweise dadurch erreicht werden, dass die in Figur 1 gezeigten sechs Leiterplatten-Strukturen auf drei Kühlplatten 16 alle gleichartig an die Leiterstäbe 12 angeschlossen sind und somit elektrisch parallel angebunden sind. Dabei wird ausgenutzt, dass die Leiterstäbe 12 oder Verbindungselemente 18 zu den Leiterstäben 12 die Kühlplatten 16 und damit auch die Leiterplatten 15 gleichartig an den Kontaktstellen durchdringen oder im Falle der äußersten Kühlplatte 16 zumindest kontaktieren.

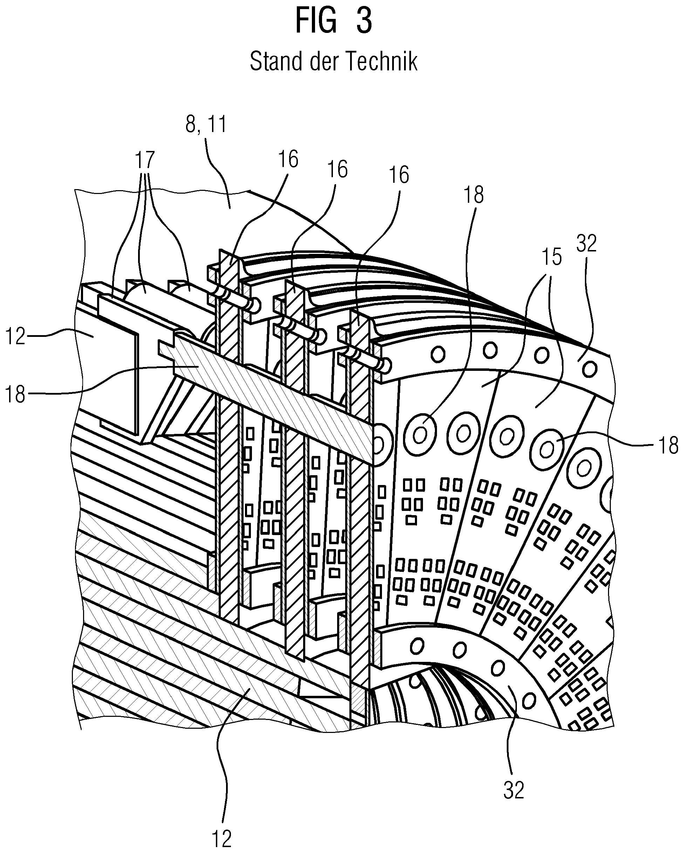

Figur 3 zeigt ein Schnittbild des Elektromotors 10 in Schrägansicht. Hierbei ist zu erkennen, dass die Verbindungselemente 18 die drei Kühlplatten 16 mechanisch tragen und durchdringen. Dies kann auch indirekt erfolgen, indem die Leiterplatten 15 über die Kühlplatten 16 radial überstehen und die Verbindungselemente die Leiterplatten in den überstehenden Bereichen durchdringen. Die Verbindungselemente 18 sind über Schuhe 17 mit den Leiterstäben 12 verbunden. Die Wechselrichter, die auf den Leiterplatten 15 in den Bereichen liegen, in denen eines der Verbindungselemente 18 eine Kühlplatte 16 durchdringt, sind parallelgeschaltet und stellen gemeinsam den Strom für den Leiterstab 12 bereit.

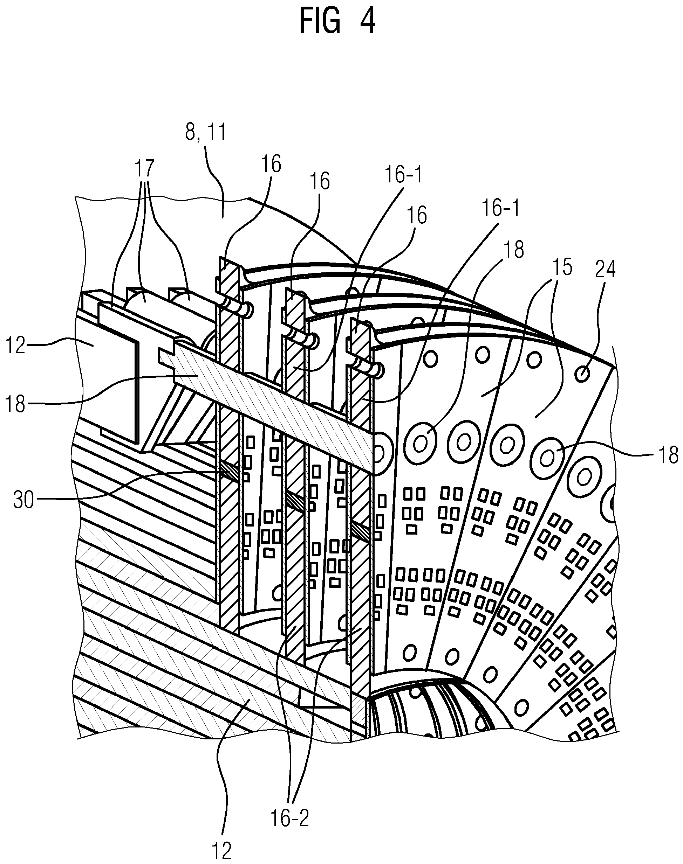

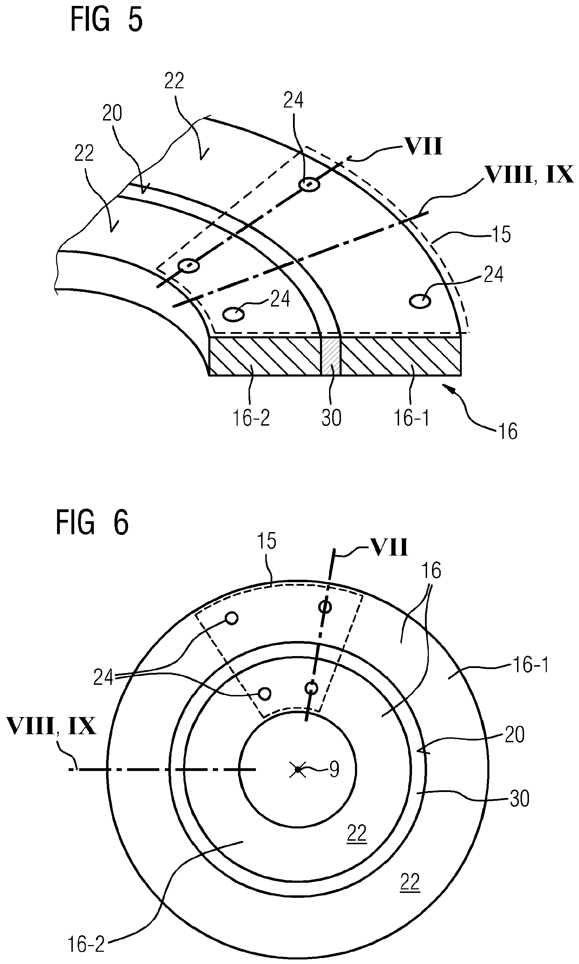

In Figur 3 sind auch Stromschienen 32 in der Ausgestaltungsform nach dem Stand der Technik dargestellt. Diese sind auf den Leiterplatten 15 aufgeschraubt und befestigen diese damit auf der Kühlplatte 16. Wenn nun eine Leiterplatte 15 defekt ist und ausgetauscht werden muss, müssen die Stromschienen 32 mit allen einzelnen Verschraubungen zu den Leiterplatten 15 entfernt werden. D. h., dass bei beispielsweise hundert Leiterplatten 15 mit je drei Verschraubungen dreihundert Verschraubungen gelöst werden müssen. Dieser Aufwand wird durch die Ausgestaltung gemäß Figur 4, und im Weiteren schematisiert und vergrößert dargestellt in den Figuren 5 bis 10, reduziert.

In Figur 4 ist die gleiche Anordnung wie in Figur 3 bezüglich der Anordnung der Kühlplatten 16 bezüglich des Elektromotors 10 und der Motorachse 9 dargestellt, wobei jedoch die Kontaktierung der Leiterplatten 15 durch Teilsegmente 16-1 und 16-2 der Kühlplatte 16 erfolgt.

In Figur 5 ist nun einen Querschnitt und ein Ausschnitt aus einer Kühlplatte 16 gegeben, die sie beispielsweise in Figur 4 angeordnet ist. Diese Kühlplatte 16 ist in zwei Teilsegmente aufgeteilt, ein erstes Teilsegment 16-1 und ein zweites Teilsegment 16-2. Beide Teilsegmente 16-1 und 16-2 sind dabei durch einen Isolierung 30 elektrisch voneinander isoliert. Betrachtet man die Kühlplatte 16 senkrecht zur Motor Achse 9 so bilden die Teilsegmente 16-1 und 16-2 sowie die Isolierung 30 eine ebene Fläche. Dabei bilden die Oberflächen der Teilsegmente 16-1 und 16-2 eine Kühlfläche 22.diese Kühlfläche 22 ist in der Draufsicht durch eine Trennungsfläche 20 unterteilt, die von der Isolierung 30 gebildet wird. Für eine vorteilhafte Wärmeableitung der Wärmemenge, die aus den Leiterplatten 15 eingetragen wird, ist es zweckmäßig, wenn die Fläche der Trennungsfläche 20 möglichst gering ist, sie sollte höchstens 20 % der Fläche der Kühlfläche 22 betragen. Besonders vorteilhaft sollte die Trennungsfläche 20 weniger als 10 %, besonders vorteilhaft weniger als 5 % der Kühlfläche 22 betragen.

In den Figuren 5 und 6 ist durch eine gestrichelte Linie die Positionierung einer Leiterplatte 15 angedeutet. Ferner sind ebenfalls Kontaktstellen 24 eingezeichnet, über die eine elektrische Kontaktierung zwischen der stromführenden Kühlplatte 16 und der Leiterplatte 15, sowie der darauf angeordneten Leistungselektronik-Bauelementen erfolgt.

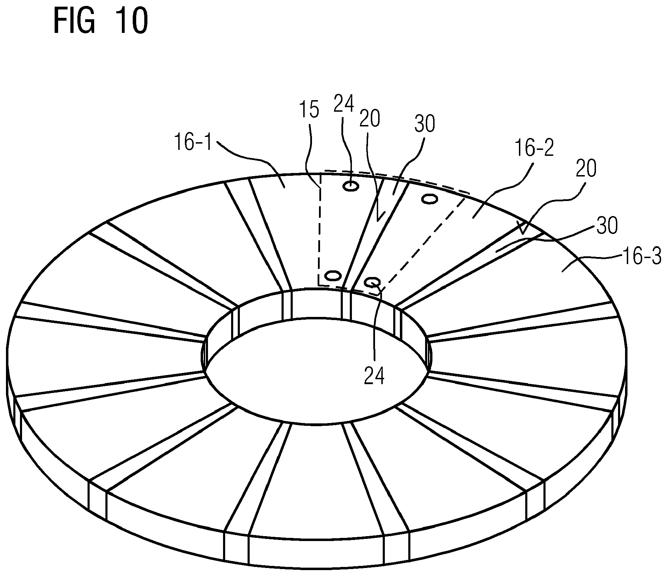

In den Figuren 5 und 6 sind die Teilsegmente 16-1 und 16-2 in Form von zwei konzentrischen Ringen ausgestaltet. Grundsätzlich sei darauf hingewiesen, dass auch andere mögliche Segmentierung an der Kühlplatte 16 zweckmäßig sein können, beispielsweise wie diese in Figur 10 dargestellt ist. In Figur 10 sind die Teilsegmente 16-1, 16-2, 16-3 in ringsegmentförmige Einheiten unterteilt. Sie weisen dabei eine ähnliche geometrischer Ausgestaltung aus, wie die Leiterplatten 15 üblicherweise und in vorteilhafter Weise ausgestaltet sind. Dabei kann es zweckmäßig sein, dass die Leiterplatten 15 jeweils zwei Teilsegmente 16-1 bis 16-2 in der Art überlappen, dass wie in Figur 10 angedeutet, eine Kontaktierung mit jeweils einem Teilsegment mit unterschiedlichem elektrischem Potenzial erfolgt. Dabei ist anzumerken, dass je nach elektrischer Verschaltung auch bei einer Gleichstrom-Versorgung der Leiterplatten mehrere stromleitenden Kontakte mit unterschiedlichen potenzialen zweckmäßig und oder erforderlich sein können.

Die Kühlplatte 16, die in ihrer Teilsegmente 16-1,16-2 und oder 16-3 segmentiert ist, ist bevorzugt aus Aluminium bzw. einer Aluminiumlegierung oder aus Kupfer bzw. einer Kupferlegierung ausgebildet. Diese Metalle sind leicht zu fertigen, leiten sehr gut Strom und haben eine hohe Wärmeleitfähigkeit.

Somit kann die Kühlplatte sowohl ihre Funktion als Stromleiter und als Kühlkörper wahrnehmen. Die Isolierung 30 hingegen ist bevorzugt aus einem isolierenden Kunststoff ausgestaltet. Die Isolierung 30 kann auch zumindest teilweise als leerer Raum ausgestaltet sein, bei dem Luft als Isoliermedium fungiert.

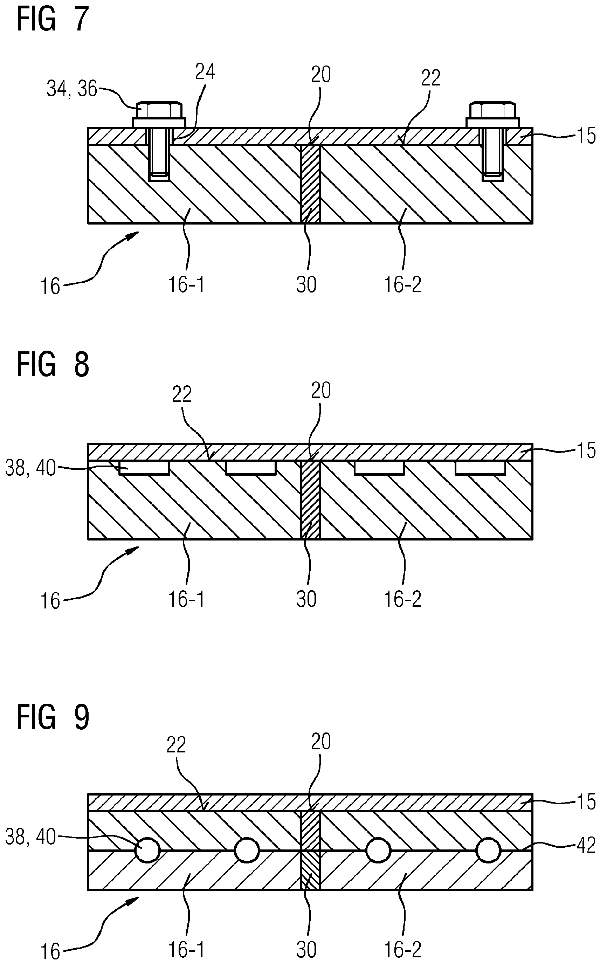

In den Figuren 7 bis 9 sind Querschnittsdarstellungen durch die Kühlplatte 16 gegeben, wie sie in der Figur 6 und der Figur 5 dargestellt ist und dort mit den Schnitten VII, VIII und IX gekennzeichnet sind. In Figur 7 ist dabei neben den Schnitten durch die Teilsegmente 16-1 und 16-2, die durch die Isolierung 30 voneinander getrennt sind und die zusammen die Kühlplatte 16 bilden, die Befestigung der Leiterplatte 15 auf der Kühlplatte 16 schematisch dargestellt. Dabei ist an einer Kontaktstelle 24 ein Befestigungsmittel 34 vorgesehen, das in Form einer Verschraubung 36 ausgestaltet ist. Die Verschraubung 36 ist ein Befestigungsmittel 34, das eine gute Kontaktierung zwischen der stromführenden Kühlplatte 16 und der Leiterplatte 15 bewirkt. Grundsätzlich können auch Nietverbindungen zweckmäßig sein, diese bewirken allerdings eine schlechte Lösbarkeit der Leiterplatten 15 in einem Schadensfall. Allerdings können auch Schnappverbindungen analog einem Schnellspanner eines Fahrradsattels eine zweckmäßige Befestigung der Leiterplatte auf der Kühlplatte mit ebenfalls guter Kontaktierung bewirken.

In den Figuren 7 bis 9 sind für die Teilsegmente 16-1 und 16-2 jeweils gleich große Querschnittsflächen dargestellt. Dies ist jedoch nicht zwingend erforderlich. Vorteilhaft ist es, wenn beide Teilsegmente 16-1 und 16-2 an eine Wärmesenke 38 angeschlossen sind. In den Figuren 8 und 9 ist die Wärmesenke 38 in Form von Kühlleitungen 40 ausgestaltet. Eine Wärmesenke kann jedoch auch ein physischer Kontakt mit einem anderen guten Wärmeleiter sein, der die Wärme von der Kühlplatte 16 weg und aus dem Motor 10 heraus leitet. Eine Wärmesenke 38 kann auch ein genügender Abstand zwischen den Kühlplatten 16 sein, der durch ein Fluid, insbesondere mit Luft durchströmt wird.

In den Figuren 8 und 9 sind mögliche Ausgestaltungen für die Anordnung von Kühlleitungen 40 durch die Kühlplatte 16 gegeben. Dabei ist in Figur 8 die Kühlleitung 40 in Nuten in der Kühlfläche 22 eingelassen. Die Kühlleitungen 40 haben Figur 8 exemplarisch einen rechteckigen Querschnitt.

In Figur 9 sind ebenfalls Kühlleitungen 40 in die Kühlplatte 16 eingebracht, diese liegen jedoch im Zentrum der Kühlplatte 16 vor. Derartige Kühlleitungen 40 lassen sich entweder durch ein Sandgussverfahren mit einem verlorenen Kern, insbesondere als Aluminium-Sandguss herstellen. Alternativ kann die Kühlplatte auch in einer horizontalen Ebene 42 geteilt sein, sodass dort die Kühlleitungen ebenfalls in Form von Nuten ausgespart sind, die beim Zusammenfügen der horizontal geteilten Kühlplatte 16 eine geschlossene Kühlleitung 40 ergeben. Die horizontal geteilten Kühlplatten können dann bei der Herstellung mittels eines Lötverfahrens zusammengefügt werden oder durch umlaufende Dichtungen abgedichtet werden. Die zweite Alternative würde es ermöglichen, weitere (nicht dargestellte) Teilsegmente zu erstellen, die ein weitere unabhängige, stromführende Potentiale bereitzustellen könnten.

Der Vorteil des beschriebenen Elektromotors 10 und der beschriebenen Anordnung der Leistungselektronik auf Kühlplatten 16 sowie Leiterplatten 15 besteht darin, dass die Kühlplatte 16, die zur Abfuhr von Wärme der leistungselektronischen Bauelementen auch im Stand der Technik dient, gleichzeitig zu deren elektrischen Kontaktierung herangezogen wird. Das hat zum einen den Vorteil, dass keine zusätzlichen Bauteile in Form von Stromleitungsschienen benötigt werden, die zum anderen nicht aufwendig elektrisch isoliert von Kühlleitungen angeordnet werden müssen. Zudem liegen diese Stromleitungsschienen nicht über den Leiterplatten 15 (aus Blickrichtung der Kühlplatte 16 gesehen), sodass bei einem Defekt einer Leiterplatte 15 nicht alle Kontaktierung der weiteren Leiterplatten 15 entfernt werden müssen. Die beschriebene Anordnung ist demnach sowohl bei der Erstmontage des Elektromotors 10 sowie bei einer möglichen Reparatur mit einem geringeren Montageaufwand und mit einem geringeren Teilebedarf belastet.

### Bezugszeichen

- 8: Stator/Rotor-Block
- 9: Motorachse
- 10: Elektromotor
- 11: Stator
- 12: Leiterstäbe
- 13: Stirnseite
- 14: Rückseite
- 15: Leiterplatten
- 16: Kühlplatte
- 16-1: erstes Teilsegment Kühlplatte
- 16-2: zweites Teilsegment Kühlplatte
- 17: Schuh
- 18: Verbindungselement
- 20: Trennungsfläche
- 22: Kühlfläche
- 24: Kontaktstellen
- 26: Halbleiterschalter
- 28: Verschraubung
- 30: Isolierung
- 32: Stromschiene Stand der Technik
- 34: Befestigungsmittel
- 36: Verschraubung
- 38: Wärmesenke
- 40: Kühlleitung
- 42: horizontale Ebene

## Patentansprüche

1. Elektromotor (10) mit:
- einem Stator (11) mit einer Mehrzahl von als Stäbe ausgestalteten Feldleitern (12),
- einer Mehrzahl von Leistungselektronikbauteilen zur Ansteuerung der Feldleiter (12),
wobei
- die Leistungselektronikbauteile auf einer oder mehreren Leiterplatten (15) angeordnet sind,
- wenigstens eine Leiterplatte (15) auf wenigstens einer Kühlplatte (16) angeordnet ist,
- die Kühlplatte (16) so angeordnet ist, dass die Feldleiter (12) mit den Feldleitern (12) elektrisch verbundenen Stromleitern (18) mit der Kühlplatte (16) in mechanischer Wirkverbindung stehen,
**dadurch gekennzeichnet**,
- die Kühlplatte (16), in mindestens zwei Teilsegmente (16-1), (16-2) segmentiert ist, die elektrisch voneinander isoliert sind,
- wobei eine Trennungsfläche (20) zwischen den Teilsegmente (16-1), (16-2) weniger als 20% einer Kühlfläche (22) beträgt und
- die Leiterplatten (15) zur Stromversorgung mit den Teilsegmenten (16-1), (16-2) der Kühlplatte (16) elektrisch kontaktiert sind.

2. Elektromotor nach Anspruch 1, **dadurch gekennzeichnet, dass** die Kontaktierung der Leiterplatte (15) an Kontaktstellen (24) mittels eines Befestigungsmittels (34) an der Kühlplatte (16) erfolgt.

3. Elektromotor nach Anspruch 2, **dadurch gekennzeichnet, dass** das Befestigungsmittel (34) in Form einer Verschraubung (36) ausgestaltet ist.

4. Elektromotor nach einem der vorhergehenden Ansprüche, **dadurch gekennzeichnet, dass** die Kühlplatte (16) mit einer Wärmesenke (38) in thermische Verbindung stehen.

5. Elektromotor nach Anspruch 4, **dadurch gekennzeichnet, dass** die Wärmesenke (38) in Form einer Kühlleitung (40) ausgestaltet ist.

6. Elektromotor nach Anspruch 5, **dadurch gekennzeichnet, dass** die Kühlleitung (40) die Kühlplatte (16) in einer horizontalen Ebene (42) durchläuft.

7. Elektromotor nach einem der vorhergehenden Ansprüche, **dadurch gekennzeichnet, dass** die Teilsegment (16-1), (16-2) ringförmig oder ringsektorförmig ausgestaltet sind.

8. Elektromotor nach einem der vorhergehenden Ansprüche, **dadurch gekennzeichnet, dass** die Kühlplatte (16) aus Aluminium oder Kupfer oder aus einer Legierung dieser Metalle gebildet ist.

9. Elektromotor nach einem der vorhergehenden Ansprüche, **dadurch gekennzeichnet, dass** die Leiterplatten (15) kreisoder ringsektorförmig ausgestaltet sind.

10. Elektromotor nach einem der vorhergehenden Ansprüche, **dadurch gekennzeichnet, dass** die Kühlplatte (16) senkrecht zur Achse (9) des Elektromotors (10) angeordnet ist.

11. Elektromotor nach einem der vorhergehenden Ansprüche, ausgestaltet, jeden der Feldleiter (12) mit einer eigenen Phase anzusteuern.

12. Elektromotor nach einem der vorhergehenden Ansprüche, bei der die Wechselrichter ausgestaltet sind zur Erzeugung einer Wechselspannung mit einer Amplitude von 200 V oder weniger, insbesondere 150 V oder weniger, insbesondere 50 V oder weniger.
